## Europäisches Patentamt

## European Patent Office

## Office européen des brevets

(11) Veröffentlichungsnummer: **0 056 829**
**B1**

(12) **EUROPÄISCHE PATENTSCHRIFT**

(45) Veröffentlichungstag der Patentschrift:
04.09.85

(51) Int. Cl.⁴: **G 03 F 5/22**

(21) Anmeldenummer: **81100520.6**

(22) Anmeldetag: **24.01.81**

(54) **Farbdriftfreie Raster für den Mehrfarbendruck.**

(43) Veröffentlichungstag der Anmeldung:
**04.08.82 Patentblatt 82/31**

(45) Bekanntmachung des Hinweises auf die Patenterteilung:
**04.09.85 Patentblatt 85/36**

(84) Benannte Vertragsstaaten:
**BE CH DE FR GB IT LI NL**

(56) Entgegenhaltungen:
**Keine**

(73) Patentinhaber: **DR.-ING. RUDOLF HELL GmbH,**
**Grenzstrasse 1-5, D-2300 Kiel 14 (DE)**

(72) Erfinder: **Wadle, Heinrich, Dr., Looper Weg 25,**
**D-2350 Neumünster (DE)**
Erfinder: **Jung, Eggert, Dr., Mühlenberg 25,**
**D-2306 Schönberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Rasterungsverfahren für den Mehrfarbendruck gemäss dem Oberbegriff des Anspruchs 1.

Bei der elektronisch-mechanischen Gravur von Druckformen, z.B. bei der Gravur von Tiefdruckzylindern, wie sie in «Der Polygraph», Heft 18/1956; «Deutscher Drucker», Nr. 22–24/1974 und «Druck-Print», 12/68, Seite 931 bis 938, im einzelnen beschrieben ist, entsteht das Problem, dass zur Vermeidung von Moiré-Effekten eine Winkelung zwischen den Rastern der Einzelfarbe eines Mehrfarbendruckes, wie es bei konventionell geätzten autotypischen Formen üblich ist, nicht durchgeführt werden kann.

Das liegt hauptsächlich daran, dass das Rasternetz einer Gravur, z.B. eines Tiefdruckzylinders, durch Nacheinandergravieren aller Rasterpunkte erfolgt, und zwar derart, dass ein Gravierkopf mit einer konstanten Aufrasterungsfrequenz seines Stichels eine Umfangslinie des Zylinders nach der anderen mit Rasternäpfchen unterschiedlicher Tiefe, aber mit konstanten Mittelpunktabständen voneinander graviert. Der Gravierkopf bewegt sich dabei kontinuierlich langsam – oder auch schrittweise – in Achsrichtung des Zylinders, und zwar um jeweils den durch das gewünschte Raster vorgegebenen achsialen Linienabstand pro Zylinderumdrehung.

Das Rasternetz ergibt sich also aus dem Zusammenspiel zwischen Drehbewegung, Vorschub und Rasterfrequenz des Gravierstichels. Es ist ohne weiteres ersichtlich, dass dabei stets die Umfangsrichtung und die Vorschubrichtung der Geometrie des Rasternetzes als Vorzugsrichtungen zugrunde liegen und eine zur Umfangsrichtung – der späteren Laufrichtung des Papiers beim Druck – gewinkelte Lage des Rasternetzes nicht zustandekommen kann.

Da nun die Anzahl der Näpfchen auf einem gegebenen Umfang und auch auf die Längeneinheit in Achsrichtung ausserordentlich exakt ist, könnte man einwenden, dass es auch bei ungewinkelten Rastern hier nicht zu Moiré-Erscheinungen kommen kann, denn Moiré-Muster entstehen durch im Abstand sich periodisch wiederholendes Aufeinanderdrucken und Nebeneinanderdrucken von Rasterpunkten zweier oder mehrerer Raster.

In der Praxis befinden sich jedoch z.B. zwischen zwei Druckwerten einer Druckmaschine etliche Meter des Naturstoffes Papier, welches seine Länge durch unterschiedliche mechanische Dehnung, Feuchtungs- oder Schrumpfprozesse zwischen den Druckwerten leicht um einen halben Rasterpunktabstand verändern kann. Durch zufälliges Aufeinanderdrucken oder Nebeneinanderdrucken der Rasterpunkte zweier oder mehrerer Farben entsteht dann das sogenannte Farbspiel, dem Moiré ähnlich, in den Ursachen aber statistisch und durchweg viel weiträumiger, so dass die bei verschiedenen Zylinderabdrucken entstehenden Drucke desselben Motivs starke Farbschwankungen aufweisen, die in der Praxis nicht tragbar sind.

Es muss hier bemerkt werden, dass auch das in der konventionellen Praxis übliche Winkeln der Raster das Moiré keineswegs «zum Verschwinden bringt». Vielmehr macht man durch Winkeln das Moiré so fein, dass seine Maschenweite nur wenig grösser ist als die Maschenweite des Rasters selbst. Es wird damit durch das endliche Auflösungsvermögen des menschlichen Auges in Leseentfernung bei hinreichend feinem Raster nicht mehr erkennbar.

Diese Gegebenheiten haben seit Bestehen der elektromechanischen Gravur, insbesondere von Tiefdruckformzylindern, zu der Aufgabenstellung geführt, in dieser Formherstellungsart Rastergeometrien zu verifizieren, die der konventionellen Winkelung in der Wirkung gleichkommen.

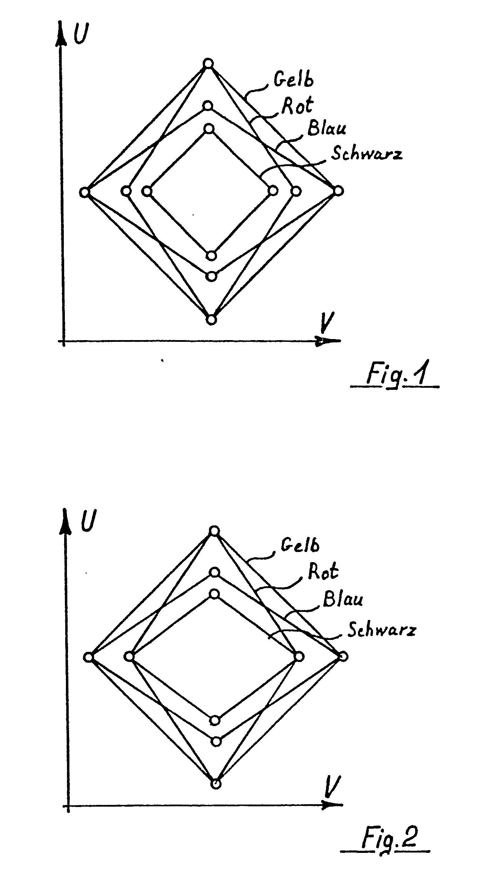

In der DE-PS 1 112 407 ist eine Art der Rasterverzerrung bei der Gravur durch geeignete Wahl der Rasterentstehungsparameter beschrieben, die diese Wirkung hat (siehe auch «Druck-Print», 12/68, Seiten 931–938). Durch «Stauchung» oder «Längung» der ursprünglich quadratischen Rastermasche in bestimmten Zahlenverhältnissen (2:3/3:2) wird der gleiche Effekt wie beim «Winkeln» erzeugt. Es ist jedoch derzeit nicht erkannt worden, dass es nur zwei praktikable Kombinationen von Rastergeometrien gibt, die die im Anspruch 1 der Schrift genannten Bedingungen erfüllen, nämlich die, dass in Umfangsrichtung auf zwei Rasterpunkte des ersten Rasters drei Rasterpunkte des zweiten Rasters fallen und umgekehrt in Vorschubrichtung drei Rasterpunkte des ersten Rasters auf zwei Rasterpunkte des zweiten Rasters fallen (vergleiche Figur 2b in der DE-PS 1 112 407). Alle anderen Kombinationen geben in einem Vierfarbedruck ein untragbares Moiré.

Lange Zeit hat man sich damit beholfen, dass man beim Zusammendruck von 4 Farben die kritischen Farben (in der Regel Rot und Blau) in je einer der genannten Rastergeometrien druckte. Sie waren damit gegeneinander farbspielfrei, und das entstehende Moiré war hinreichend fein. Die übrigen Farben (Schwarz und Gelb) sind hinsichtlich des Farbspiels nicht ganz so empfindlich und wurden deshalb je einer der beiden Rastergeometrien zugeordnet. Ihr Farbspiel mit Rot und Blau wurde in Kauf genommen, war jedoch stets ein kritischer Punkt der gravierten Druckformen. Seither besteht die Aufgabe, Kombinationen in der Rasterkonfiguration zu finden, die es gestatten, mehr als zwei Farben farbspielfrei und mit hinreichend kleiner Moiré-Periode zu drucken. Weiterhin müssen solche Konfigurationen auch in den heute üblichen Maschinen der Repro-Technik, seien es Graviermaschinen oder Scanner, verifizierbar sein. Diese Aufgabe liegt der vorliegenden Erfindung zugrunde. Die Aufgabe wird durch die im Anspruch 1 bzw. 2 genannten Mittel gelöst. Vorteilhafte Weiterbildungen sind in den Unteransprüchen genannt.

Im folgenden wird die Erfindung anhand der Figuren 1 und 2 erläutert: Es zeigen: Figur 1 und 2 schematische Anordnung der Rasterpunkte für Farbspiel und Moiré-freie Mehrfarbendrucke.

Im Kern geht die Erfindung davon aus, dass Rasterkonfigurationen zusammengedruckt werden, die nicht nur hinsichtlich der Verzerrung aus der ursprünglich quadratischen Form, sondern ausserdem in der Rasterweite, d.h. der tatsächlichen Anzahl der Rasterelemente pro Flächeneinheit, erheblich variiert werden. Erweitert man nämlich die in Anspruch 1 der DE-PS 1 112 407 präzisierte Forderung, dass die Anzahl der Rasterelemente pro Flächeneinheit annähern gleich zu sein hat, dahin gehend, dass die Anzahl der Rasterelemente pro Flächeneinheit bei den einzelnen Farben erheblich unterschiedlich gewählt wird, dann erkennt man, dass sich weit mehr Kombinationen ergeben als die obengenannte Kombination 2:3/3:2. Die Praxis hat gezeigt, dass deutliche Abweichungen von einer Grundrasterweite für die verschiedenen Farben nicht zu einer nennenswerten Qualitätseinbusse führen, insbesondere dann, wenn die Abweichung zu feineren Rastern hingeht. Es hat sich sogar gezeigt, dass unter diesen Voraussetzungen nicht einmal exakt rationale Verhältnisse in «Streckung» oder «Stauchung» der quadratischen Ursprungsraster eingehalten werden müssen. Geringfügige Abweichungen von den ermittelten Konfigurationen führen nicht zu Farbspiel, sondern ändern nur das Feinmoiré ausserordentlich wenig in Phasenlage, Maschenform und Periode. Als Beispiel seien 2 praktikable Konfigurationen für einen vierfarbigen, hochwertigen Katalog-Tiefdruck angeführt.

Im ersten Beispiel werden die ursprünglich benutzten Verzerrungen 2:3/3:2 mit je einem gröberen und einem feineren quadratischen Raster kombiniert. Figur 1 veranschaulicht die 4 Konfigurationen, wobei U die Umfangsrichtung des Druckzylinders bezeichnet, V die Vorschubrichtung des Gravierorgans. Die Eckpunkte der Vierecke sind als die Mittelpunkte zugehöriger Rasterpunkte aufzufassen. Das gröbere quadratische Raster, dessen Rasterpunkte sowohl in U-Richtung als auch in V-Richtung den Abstand der Rasterpunkte des Rotrasters in U-Richtung haben, wird vorteilhafterweise der gelben Farbe zugeordnet, da diese generell die Rasterstruktur im Druck wegen ihrer grossen Helligkeit kaum erkennen lässt. Rot und Blau werden in 2:3-Konfiguration wie bisher gedruckt. Damit ist die Anzahl der Rasterelemente pro Flächeneinheit im Gelbraster um den Faktor 2/3 kleiner als beim Rot- bzw. Blauraster. Der schwarzen Farbe wird ein quadratisches Raster zugeordnet, welches doppelt so fein ist wie das Gelb-Raster, was im übrigen der Wiedergabe feiner Schriften in vorteilhafter Weise zugute kommt. Die Anzahl der Rasterelemente pro Flächeneinheit ist damit im Schwarzraster um den Faktor 4 grösser als beim Gelbraster.

Eine zweite Konfiguration für den Vierfarbendruck hat sich ebenfalls als praktikabel erwiesen: (Figur 2)

Dabei stehen Gelb, Rot und Blau in gleicher Rasterordnung wie beim ersten Beispiel. Beim Schwarzraster liegen benachbarte Rasterpunkte jedoch nicht auf den Ecken eines Quadrates. Ihr Abstand in Vorschubrichtung V entspricht vielmehr dem Abstand der Punkte des Rotrasters, während ihr Abstand in Umfangsrichtung U gleich der Hälfte des Abstandes des Rotrasters in U-Richtung ist.

Weitere Kombinationen sind denkbar. Es sei noch einmal hervorgehoben, dass die Streckungen und Stauchungen in U- bzw. V-Richtung nicht einmel exakt eingehalten werden müssen. Abweichungen in der Grössenordnung von einigen Prozent sind im Druck nicht erkennbar. Das gleiche gilt für die Rasterweiten bei den Rastern der Einzelfarben. Grundsätzlich kann man natürlich auch die den einzelnen Rastern zugeordneten Farben vertauschen.

Es liegt weiterhin im Rahmen der Erfindung, einen Farbsatz zu erstellen, bei dem nur in einem Raster von dem bisherigen Verfahren abgewichen wird und nur in diesem Auszug ein Raster gemäss der Erfindung zur Anwendung kommt.

Das Verfahren bezieht sich nicht auf die Gravur von Druckformen allein; vielmehr können die beschriebenen Rastergeometrien ebenso bei der Erstellung gerasterter Farbauszüge in Scannern für alle Druckverfahren, ja sogar als entsprechende Kopieglasraster bei der klassischen Herstellung durch Ätzen im grafischen Gewerbe Anwendung finden.

Die Erfindung findet Anwendung in dem gesamten Gebiet der Reproduktionstechnik, insbesondere in der elektronischen Reproduktionstechnik.

**Patentansprüche**

Gegenstand der Erfindung

1. Rasterungsverfahren für den Mehrfarbendruck, wobei die Rasterelemente zeitlich nacheinander punkt- und zeilenweise durch Gravierung, Erosion oder Belichtung elektromechanisch durch Hochenergiestrahlung oder elektro-optisch erzeugt werden, dadurch gekennzeichnet, dass Rastersorten verwendet werden, bei denen sich sowohl die Zeilenabstände (Vorschubrichtung) in den verschiedenen Rastern eines Farbauszugsatzes zueinander als auch die Rasterpunktabstände innerhalb der Zeilen dieses Rastersatzes zueinander etwa wie kleine rationale Zahlen verhalten und dass zusätzlich die Anzahl der Rasterpunkte pro Flächeneinheit in mindestens 2 Rastern eines Farbsatzes um einen Faktor zwischen 1,5 und 4 unterschiedlich sind.

2. Rasterungsverfahren für den Mehrfarbendruck, wobei die Rasterelemente zeitlich nacheinander punkt- und zeilenweise durch Gravierung, Erosion oder Belichtung elektromechanisch durch Hochenergiestrahlung oder elektro-optisch erzeugt werden, dadurch gekennzeichnet, dass Rastersorten verwendet werden, bei denen sich sowohl die Zeilenabstände (Vorschubrichtung) in den verschiedenen Rastern eines Farbauszugsatzes zueinander als auch die Rasterpunktabstände innerhalb der Zeilen dieses Rastersatzes zueinander exakt wie kleine rationale Zahlen verhalten und dass zusätzlich die Anzahl der Rasterpunkte pro Flächeneinheit in mindestens 2 Rastern eines Farbsatzes um einen Faktor zwischen 1,5 und 4 unterschiedlich sind.

3. Rasteranordnung nach Anspruch 1 oder 2, dadurch gekennzeichnet, dass die Umfangsabstände von vier Rastern sich verhalten wie 3:3:2:1,5 und die entsprechenden Vorschubabstände sich verhalten wie 3:2:3:1,5.

4. Rasteranordnung nach Anspruch 1 oder 2, dadurch gekennzeichnet, dass die Umfangsabstände von vier Rastern sich verhalten wie 3:3:2:1,5 und die entsprechenden Vorschubabstände sich verhalten wie 3:2:3:2.

5. Rasterungsverfahren für die konventionelle Druckformherstellung durch Ätzung mittels Kopie-Glasraster oder Kontaktraster, dadurch gekennzeichnet, dass die Glas- oder Kontaktraster für die verschiedenen Farben eines Farbsatzes unterschiedliche Rasterkonfigurationen aufweisen, die geometrisch denen entsprechen, die durch das im Anspruch 1 oder 2 genannte Verfahren entstehen.

## Claims

1. Screening method for multicolour printing, the screen elements being produced in chronological succession dot by dot and line by line by engraving, erosion or exposure, electromechanically, by high-energy radiation, or electro-optically, characterized in that screens are utilized of a type in which the line spacings (feed direction) operate with respect to each other in the different screens of a set of colour separations, as well as the screen dot spacings within the lines of this set of screens, approximately like small rational numbers and that – additionally – the number of screen dots per areal unit in at least two screens of a set of colour separations differs from each other by a factor of betwen 1.5 and 4.

2. Screening method for multicolour printing, the screen elements being produced in chronological succession dot by dot and line by line by engraving, erosion or exposure, electromechanically, by high-energy radiation, or electro-optically, characterized in that screens are utilized of a type in which the line spacings (feed direction) operate with respect to each other in the different screens of a set of colour separations as well as the screen dot spacings within the lines of this set of screens precisely like small rational numbers and that – additionally – the number of screen dots per areal unit in at least two screens of a set of colour separations differs by a factor of between 1.5 and 4.

3. Screen layout according to claim 1 or 2, characterized in that the peripheral spacings of four screens are in a relationship of 3:3:2:1.5 and the corresponding feed spacings in a relationship of 3:2:3:1.5.

4. Screen layout according to claim 1 or 2, characterized in that the peripheral spacings of four screens are in a relationship of 3:3:2:1.5 and the corresponding feed spacings in a relationship of 3:2:3:2.

5. Screen production method for the conventional production of printing blocks by etching by means of glass or contact copying screens, characterized in that the glass or contact screens for the different colours of a set of colour separations have different screen configurations which correspond geometrically to those produced by the method defined in claim 1 or 2.

## Revendications

1. Procédé de tramage pour l'impression polychrome, procédé dans lequel les éléments de trame sont obtenus par points et par lignes successivement, par gravure, érosion ou exposition à la lumière, électro-mécaniquement par rayonnement à haute énergie ou bien électro-optiquement, procédé caractérisé en ce qu'on utilise des sortes de trames dans lesquelles aussi bien les intervalles de lignes (direction d'avance) dans les différentes trames d'un jeu d'extrait de couleurs, qu'également les intervalles entre points de trame à l'intérieur des lignes de ce jeu de trames, se présentant entre eux à peu près comme de petits nombres rationnels et qu'en outre les nombres de points de trames par unité de surface dans au moins deux trames d'un jeu de couleurs diffèrent entre eux d'un facteur compris entre 1,5 et 4.

2. Procédé de tramage pour l'impression polychrome, procédé dans lequel les éléments de trame sont obtenus par points et par lignes successivement, par gravure, érosion ou exposition à la lumière, électro-mécaniquement par rayonnement à haute énergie ou bien électro-optiquement, procédé caractérisé en ce qu'on utilise des sortes de trames dans lesquelles aussi bien les intervalles de lignes (direction d'avance) dans les différentes trames d'un jeu d'extrait de couleurs, qu'également les intervalles entre points de trame à l'intérieur des lignes de ce jeu de trames, se présentant entre eux exactement comme de petits nombres rationnels et qu'en outre les nombres de points de trames par unité de surface dans au moins deux trames d'un jeu de couleurs diffèrent entre eux d'un facteur compris entre 1,5 et 4.

3. Dispositif de trame selon revendication 1 ou 2, caractérisé en ce que les intervalles périphériques de quatre trames se présentent comme 3:3:2:1,5 tandis que les intervalles d'avance correspondants se présentent comme 3:2:3:1,5.

4. Dispositif de trame selon revendication 1 ou 2, caractérisé en ce que les intervalles périphériques de quatre trames se présentent comme 3:3:2:1,5 tandis que les intervalles d'avance correspondants se présentent comme 3:2:3:2.

5. Procédé de tramage pour la réalisation conventionnelle de clichés d'impression par gravure chimique en reproduisant des trames sur verre ou des trames de contact, procédé caractérisé en ce que les trames sur verre ou les trames de contact comportent pour les différentes couleurs d'un jeu de couleurs des configurations de trames différentes, qui correspondent géométriquement à celles obtenues par le procédé mentionné dans la revendication 1 ou la revendication 2.

*Fig.1*

*Fig.2*